# EUROPEAN PATENT SPECIFICATION

(11) **EP 0 997 033 B1**
(45) Date of publication and mention of the grant of the patent: **05.09.2007**
(21) Application number: 98933351.3
(22) Date of filing: 15.07.1998
(51) Int. Cl.: G06T 1/00, H04N 1/00, H04N 1/21

(54) **A REPLENISHABLE ONE TIME USE CAMERA SYSTEM**
NACHFÜLLBARES EINWEG-KAMERASYSTEM
SYSTEME D'APPAREIL PHOTOGRAPHIQUE JETABLE RECHARGEABLE

(30) Priority: 15.07.1997 AU PO799197; 12.12.1997 AU PP089597; 12.12.1997 AU PP087097; 12.12.1997 AU PP086997; 12.12.1997 AU PP088797; 12.12.1997 AU PP088597; 12.12.1997 AU PP088497; 12.12.1997 AU PP088697; 12.12.1997 AU PP087197; 12.12.1997 AU PP087697; 12.12.1997 AU PP087797; 12.12.1997 AU PP087897; 12.12.1997 AU PP087997; 12.12.1997 AU PP088397; 12.12.1997 AU PP088097; 12.12.1997 AU PP088197
(43) Date of publication of application: 03.05.2000
(73) Proprietor: Silverbrook Research Pty. Limited, Balmain, NSW 2041 (AU)
(72) Inventor: SILVERBROOK, Kia, Leichhardt, NSW 2040 (AU); TRELOAR, Peter, Chippendale, NSW 2008 (AU)
(74) Representative: Kinsler, Maureen Catherine
(86) International application number: PCT/AU1998/000549
(87) International publication number: WO 1999/004551

(56) References cited:
- EP-A- 0 382 044
- EP-A- 0 398 295
- EP-A- 0 512 709
- EP-A- 0 571 093
- EP-A- 0 761 450
- WO-A-91/14336
- WO-A-95/16323
- WO-A-96/32265
- WO-A-97/06958
- WO-A-98/18253
- GB-A- 2 263 841
- US-A- 4 074 324
- US-A- 4 937 676
- US-A- 5 040 002
- US-A- 5 322 594
- US-A- 5 481 280
- US-A- 5 557 310
- PATENT ABSTRACTS OF JAPAN vol. 017, no. 377 (M-1446), 15 July 1993 (1993-07-15) -& JP 05 064894 A (BROTHER IND LTD), 19 March 1993 (1993-03-19)
- PATENT ABSTRACTS OF JAPAN vol. 017, no. 537 (M-1487), 28 September 1993 (1993-09-28) -& JP 05 147284 A (MITA INC CO LTD), 15 June 1993 (1993-06-15)
- PATENT ABSTRACTS OF JAPAN vol. 016, no. 540 (P-1450), 10 November 1992 (1992-11-10) -& JP 04 204592 A (NIPPON TYPEWRITER CO), 24 July 1992 (1992-07-24)
- PATENT ABSTRACTS OF JAPAN vol. 1997, no. 02, 28 February 1997 (1997-02-28) -& JP 08 267730 A (OLYMPUS OPTICAL CO LTD), 15 October 1996 (1996-10-15)
- PATENT ABSTRACTS OF JAPAN vol. 17, no. 483 (M-1472), 2 September 1993 (1993-09-02) & JP 05 116408 A (NEC CORP), 14 May 1993 (1993-05-14)
- PATENT ABSTRACTS OF JAPAN vol. 18, no. 304 (M-1619), 10 June 1994 (1994-06-10) & JP 06 064262 A (NEC CORP), 8 March 1994 (1994-03-08)

## Description

### Field of the Invention

The present relates substantially to the concept of a disposable camera having instant printing capabilities and in particular, discloses A Low Cost Disposable Camera System.

### Background of the Invention

Recently, the concept of a "single use" disposable camera has become an increasingly popular consumer item. Disposable camera systems presently on the market normally include an internal film roll and a simplified gearing mechanism for traversing the film roll across an imaging system including a shutter and lensing system. The user, after utilising a single film roll returns the camera system to a film development centre for processing. The film roll is taken out of the camera system and processed and the prints returned to the user. The camera system is then able to be re-manufactured through the insertion of a new film roll into the camera system, the replacement of any wom or wearable parts and the re-packaging of the camera system in accordance with requirements. In this way, the concept of a single use "disposable" camera is provided to the consumer.

Recently, a camera system has been proposed by the present applicant which provides for a handheld camera device having an internal print head, image sensor and processing means such that images sense by the image sensing means, are processed by the processing means and adapted to be instantly printed out by the printing means on demand. The proposed camera system further discloses a system of internal "print rolls" carrying print media such as film on to which images are to be printed in addition to ink to supplying the printing means for the printing process. The print roll is further disclosed to be detachable and replaceable within the camera system.

Unfortunately, such a system is likely to only be constructed at a substantial cost and it would be desirable to provide for a more inexpensive form of instant camera system which maintains a substantial number of the quality aspects of the aformentioned arrangement.

In particular, in any "disposable camera" it would be desirable to provide for a simple and rapid form of replenishment of the consumable portions in any disposable camera so that the disposable camera can be readily and rapidly serviced by replenishment and return to the market place.

It would be further desirable to provide for a simple means of storage of replenishable portions of a displosable camera system to allow for their rapid replenishment.

It would be further desirable to provide, in such a camera system, an ink cartridge for the storage of inks to be utilized in the printing out of images.

It would be desirable to provide for an extremely low cost camera system having as great quality as possible. In this respect, the camera system, as previously proposed should include mechanisms for sensing and processing sensed images in addition to mechanisms for printing out the images on print media via a printhead system. It would be further desirable to provide for a system having a convenient and compact arrangement of components such that they can be inexpensively manufactured in an inexpensive manner so as to allow for the readily disposable form of printing.

In any form of disposable camera arrangement, there will be the attraction for clone manufacturers to attempt to copy the process of refurbishing a used camera so as to derive profit from the refurbishment process. Unfortunately, such refurbishment may cause untold damage to the camera in particular in use of inappropriate inks and print media within the camera. The inappropriate use of such materials may result in an inferior quality product, especially where the refurbishment is done by a counterfeiter wishing to pass off their product as being one of the "originals". In this respect, the damage to the camera may be permanent, resulting in an inferior product where the consumer will readily blame the manufacturer for the production of such an inferior product even though it may not be the manufacturer's fault.

It would therefore be desirable to provide for a camera and refilling processing system which alleviates these problems thereby providing the consumers with a better quality product and a higher level of quality assurance.

In the field of photography, three important effects are of great relevance. The first is the distinction between colour and black and white. A significant portion of photography now utilises colour, however a non-insignificant portion of photography still is steeped in the field of black and white photography. Additionally, sepia tones have been generally utilised in traditional camera photography and are still highly popular for the production of traditional looking camera photographs especially with wedding photos or the like. It would therefore be desirable to be able to readily provide for the selection between these multiple different types of outputs such that a user can readily utilise any of the different output formats.

Further, it is desirable to provide as versatile a one time use camera system as possible so that it can produce a substantially number of different specialized effects instantly on demand.

Unfortunately, on a disposable camera, it is desirable to provide as low a degree of functional complexity as possible in addition to minimizing power requirements. In this respect, it is necessary to dispense with as much of the user interface complexity as possible in addition to providing for efficient operation.

Unfortunately, such a system is likely to only be constructed at a substantial cost and it would be desirable to provide for a more inexpensive form of instant camera system which maintains a substantial number of the quality aspects of the aforementioned arrangement.

It would be further advantageous to provide for the effective interconnection of the sub components of a camera system.

It would be advantageous to provide for a camera system having an effective color correction or gamut remapping capabilities.

Unfortunately, such a system is likely to only be constructed at a substantial cost and it would be desirable to provide for a more inexpensive form of instant camera system which maintains a substantial number of the quality aspects of the aforementioned arrangement.

It would be further advantageous to provide for the effective interconnection of the sub components of a camera system and for the effective driving of moveable parts within the camera system.

It would be further advantageous to provide for the effective interconnection of the sub components of a camera system.

Further, as it is proposed utilising such a re-capping mechanism in a disposable handheld camera system, it will be desirable to provide for an extremely inexpensive form of re-capping mechanism that can be utilised in an inexpensive form of disposable camera.

It would be further desirable to provide for a simplified form of automated picture counting in a disposable camera system.

Unfortunately, such a system is likely to only be constructed at a substantial cost and it would be desirable to provide for a more inexpensive form of instant camera system which maintains a substantial number of the quality aspects of the aforementioned arrangement.

The document WO 97/06958 discloses an electronic imaging camera including a printer assembly for providing instant images.

### Summary of the Invention

According to the present invention, there is provided a handheld camera system as claimed in claim 1.

### Brief Description of the Drawings

Notwithstanding any other forms which may fall within the scope of the present invention, preferred forms of the invention will now be described, by way of example only, with reference to the accompanying drawings in which:
Fig. I illustrated a side front perspective view of the assembled camera of the preferred embodiment;
Fig. 2 illustrates a back side perspective view, partly exploded, of the preferred embodiment;
Fig. 3 is a side perspective view of the chassis of the preferred embodiment;
Fig. 4 is a side perspective view of the chassis illustrating the insertion of the electric motors;
Fig. 5 is an exploded perspective of the ink supply mechanism of the preferred embodiment;
Fig. 6 is a side perspective of the assembled form of the ink supply mechanism of the preferred embodiment;
Fig. 7 is a front perspective view of the assembled form of the ink supply mechanism of the preferred embodiment;
Fig. 8 is an exploded perspective of the platten unit of the preferred embodiment;
Fig. 9 is a side perspective view of the assembled form of the platten unit;
Fig. 10 is also a perspective view of the assembled form of the platten unit;
Fig. 11 is an exploded perspective unit of the printhead recapping mechanism of the preferred embodiment;
Fig. 12 is a close up exploded perspective of the recapping mechanism of the preferred embodiment;
Fig. 13 is an exploded perspective of the ink supply cartridge of the preferred embodiment;
Fig. 14 is a close up perspective partly in section of the internal portions of the ink supply cartridge in an assembled form;
Fig. 15 is a schematic block diagram of one form of chip layer of the image capture and processing chip of the preferred embodiment;
Fig. 16 is an exploded perspective illustrating the assembly process of the preferred embodiment;
Fig. 17 illustrates a front exploded perspective view of the assembly process of the preferred embodiment;
Fig. 18 illustrates a side perspective view of the assembly process of the preferred embodiment;
Fig. 19 illustrates a side perspective view of the assembly process of the preferred embodiment;
Fig. 20 is a perspective view illustrating the insertion of the platten unit in the preferred embodiment;
Fig. 21 illustrates the interconnection of the electrical components of the preferred embodiment;
Fig. 22 illustrates the process of assembling the preferred embodiment; and
Fig. 23 is a perspective view further illustrating the assembly process of the preferred embodiment.

### Description of the Preferred Embodiment

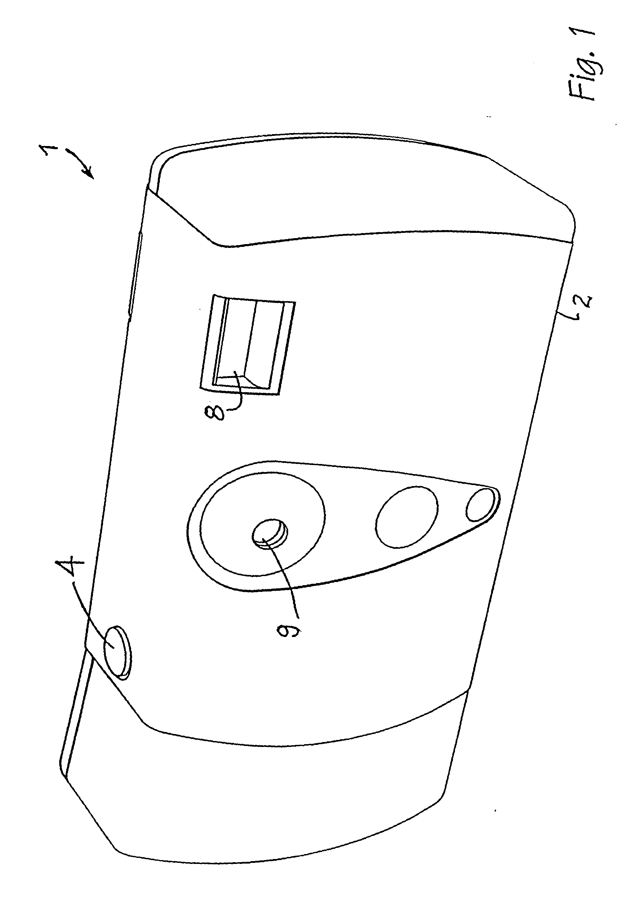

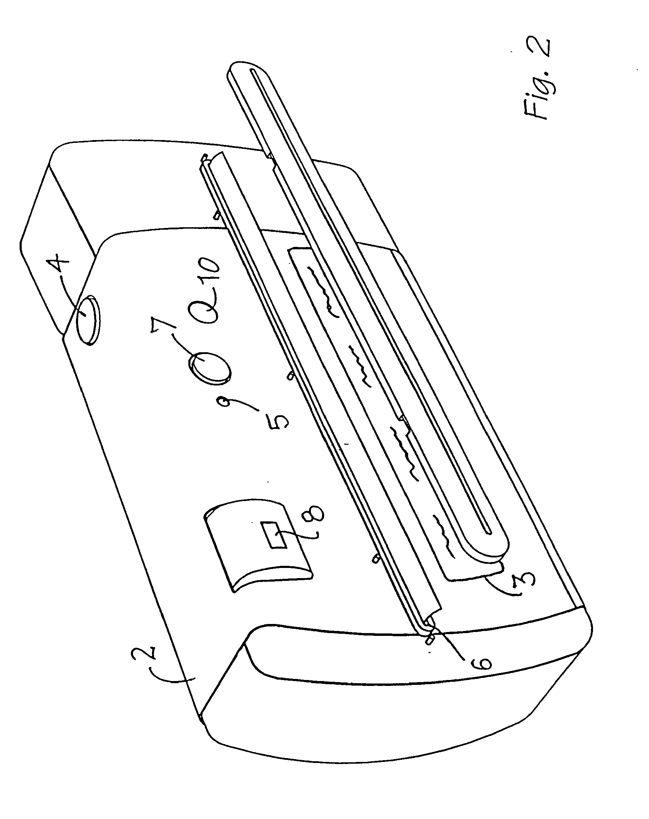

Turning initially simultaneously to Fig. 1, and Fig. 2 there is illustrated perspective views of an assembled camera constructed in accordance with the preferred embodiment with Fig. 1 showing a front side perspective view and Fig. 2 showing a back side perspective view. The camera 1 includes a paper or plastic film jacket 2 which can include simplified instructions 3 for the operation of the camera system 1. The camera system 11 includes a first "take" button 4 which is depressed to capture an image. The captured image is output via output slot 6. A further copy of the image can be obtained through depressing a second "printer copy" button 7 whilst an LED light 5 is illuminated. The camera system also provides the usual view finder 8 in addition to a CCD image capture/lensing system 9.

The camera system 1 provides for a standard number of output prints after which the camera system 1 ceases to function. A prints left indicator slot 10 is provided to indicate the number of remaining prints. A refund scheme at the point of purchase is assumed to be operational for the return of used camera systems for recycling.

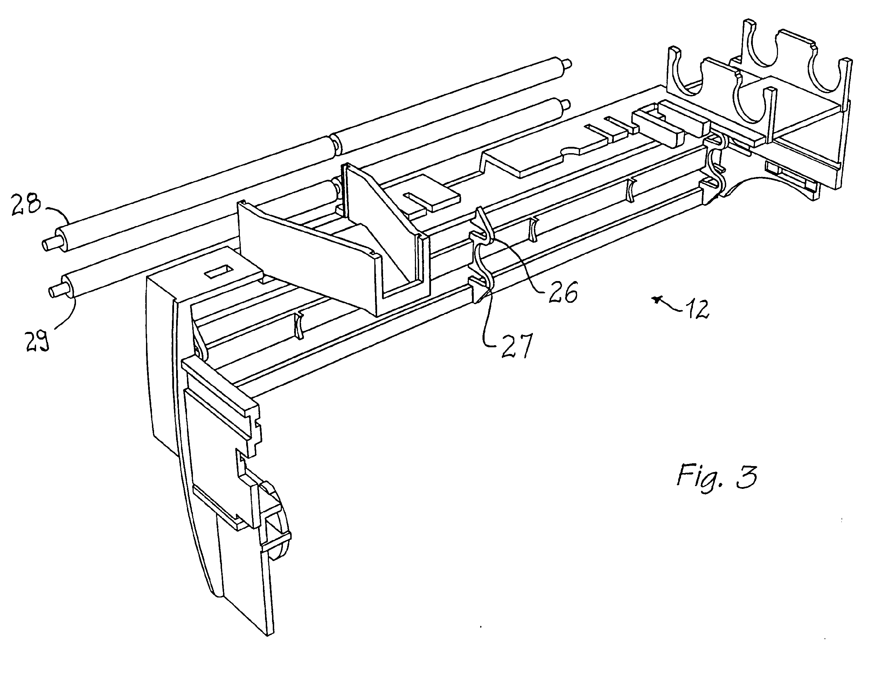

Turning now to Fig. 3, the assembly of the camera system is based around an internal chassis 12 which can be a plastic injection molded part. A pair of paper pinch rollers 28, 29 utilized for decurling are snap fitted into corresponding frame holes eg. 26, 27.

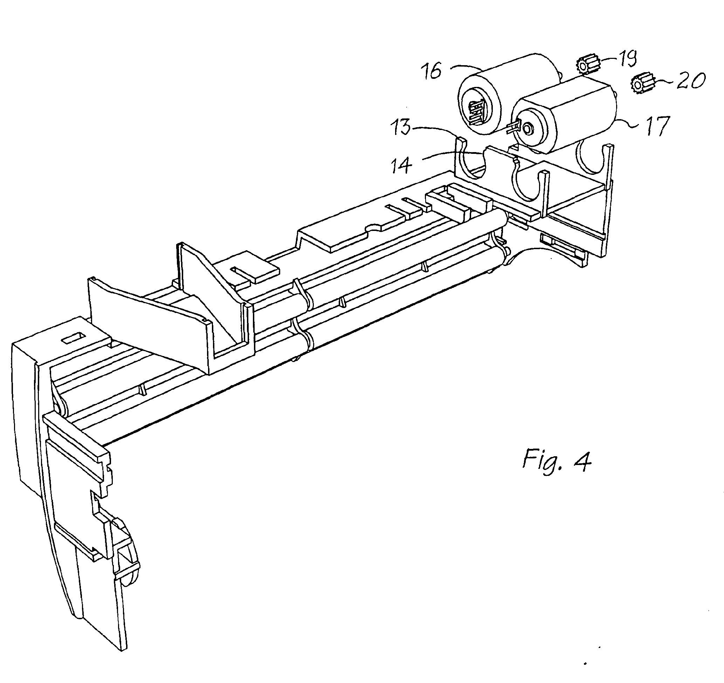

As shown in Fig. 4, the chassis 12 includes a series of mutually opposed prongs eg. 13, 14 into which is snapped fitted a series of electric motors 16, 17. The electric motors 16, 17 can be entirely standard with the motor 16 being of a stepper motor type and include a cogged end portion 19, 20 for driving a series of gear wells. A first set of gear wells is provided for controlling a paper cutter mechanism and a second set is provided for controlling print roll movement.

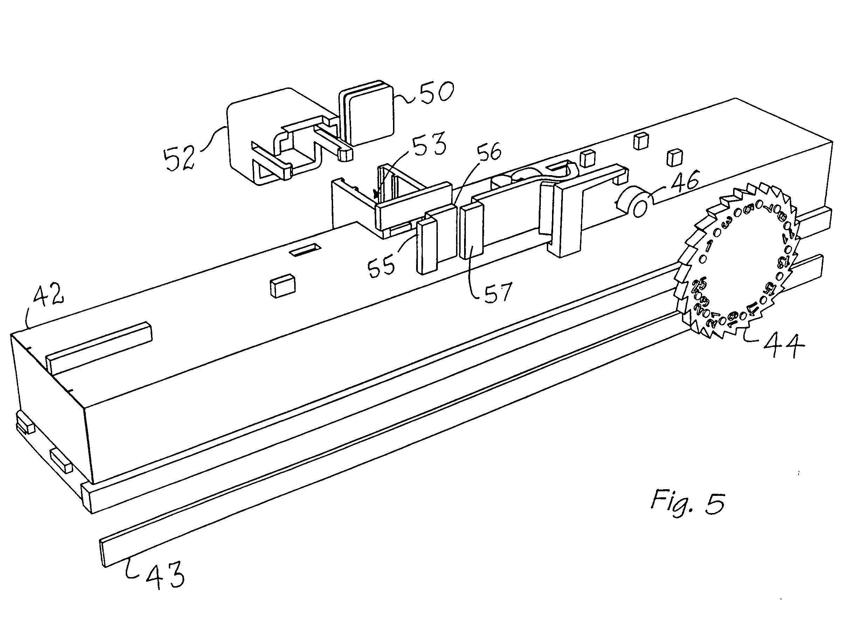

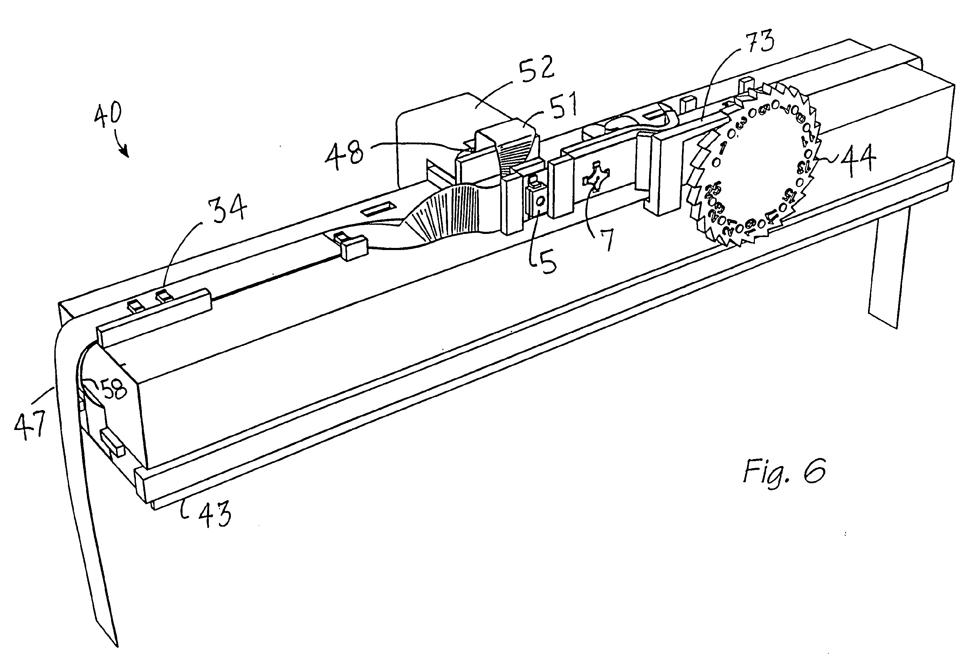

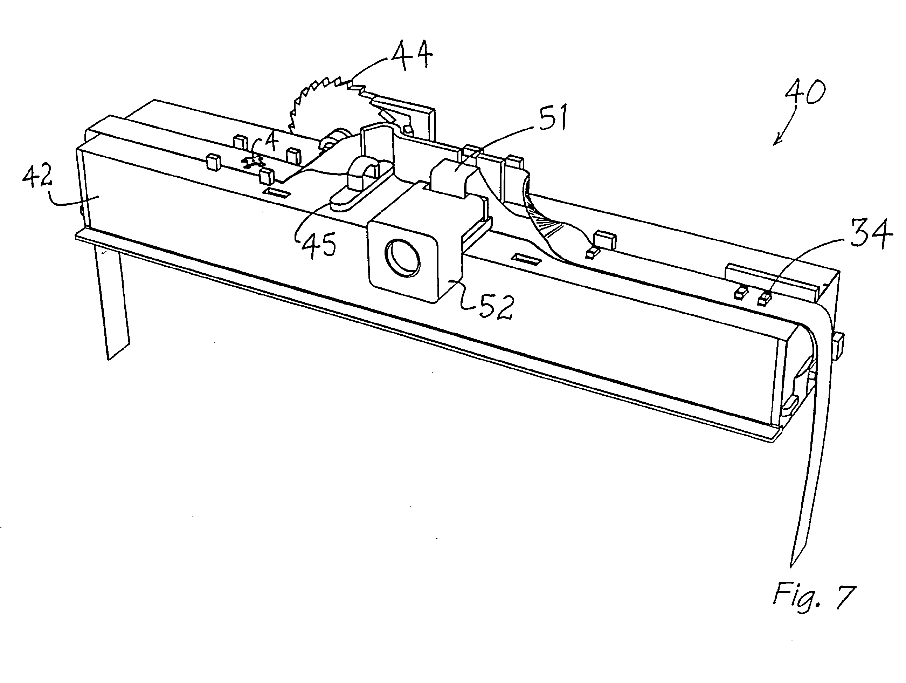

Turning next to Figs. 5 to 7, there is illustrated an ink supply mechanism 40 utilized in the camera system. Fig. 5 illustrates a back exploded perspective view, Fig. 6 illustrates a back assembled view and Fig. 7 illustrates a front assembled view. The ink supply mechanism 40 is based around an ink supply cartridge 42 which contains printer ink and a print head mechanism for printing out pictures on demand. The ink supply cartridge 42 includes a side aluminium strip 43 which is provided as a shear strip to assist in cutting images from a paper roll.

A dial mechanism 44 is provided for indicating the number of "prints left". The dial mechanism 44 is snap fitted through a corresponding mating portion 46 so as to be freely rotatable.

As shown in Fig. 6, the print head includes a flexible PCB strip 47 which interconnects with the print head and provides for control of the print head. The interconnection between the Flex PCB strip and an image sensor and print head chip can be via Tape Automated Bonding (TAB) Strips 51, 58. A moulded aspherical lens and aperture shim 50 (Fig. 5) is also provided for imaging an image onto the surface of the image sensor chip normally located within cavity 53 and a light box module or hood 52 is provided for snap fitting over the cavity 53 so as to provide for proper light control. A series of decoupling capacitors eg. 34 can also be provided. Further a plug 45 (Fig. 7) is provided for re-plugging ink holes after refilling. A series of guide prongs eg. 55-57 are further provided for guiding the flexible PCB strip 47.

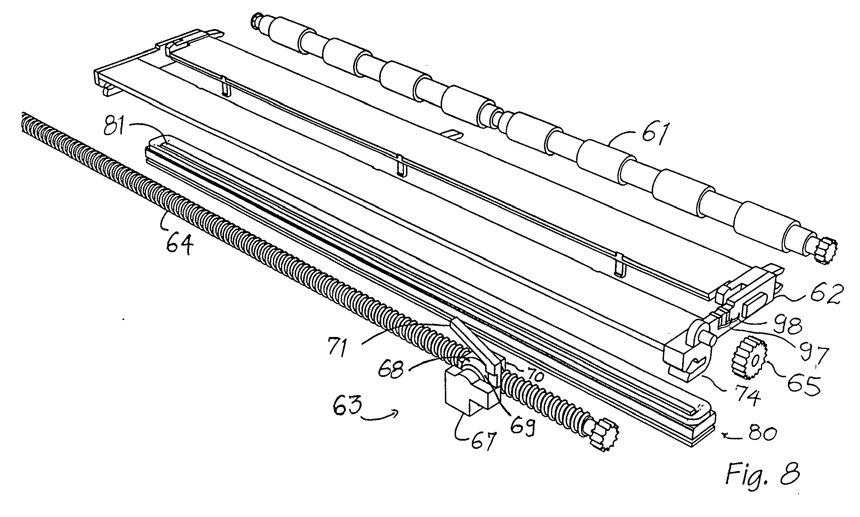

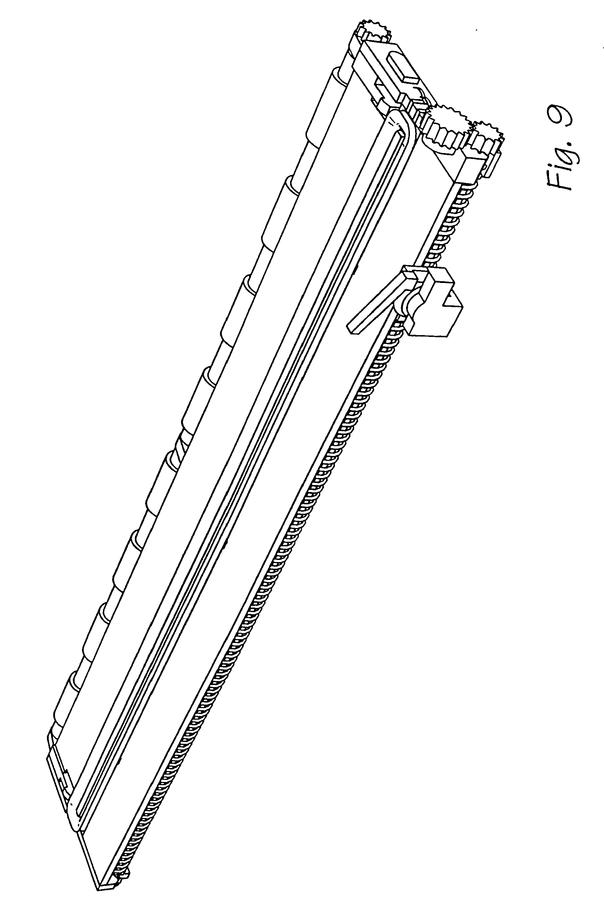

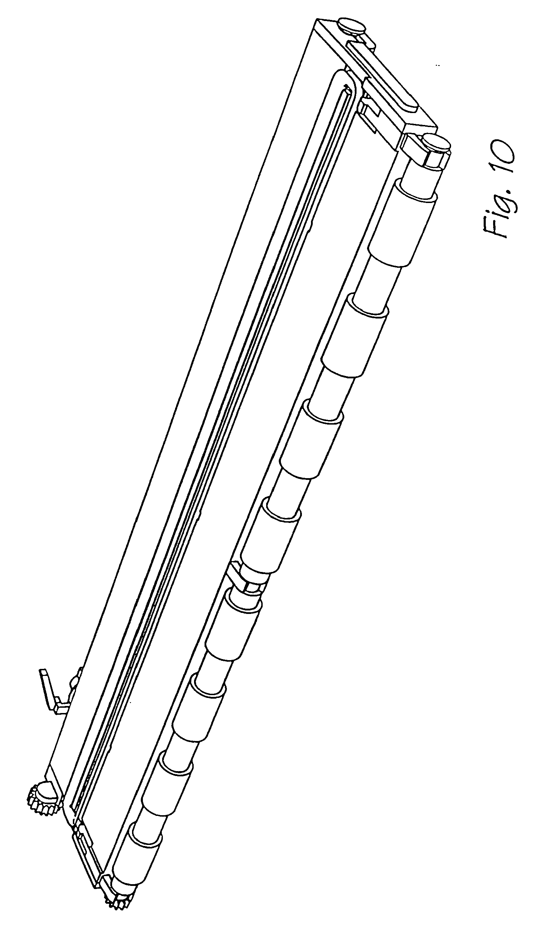

The ink supply mechanism 40 interacts with a platten unit which guides print media under a printhead located int eh ink supply mechanism. Fig. 8 shows an exploded view of the platten unit 60, while Figs. 9 and 10 show assembled views of the platten unit. The platten unit 60 includes a first pinch roller 61 which is snap fitted to one side of a platten base 62. Attached to a second side of the platten base 62 is a cutting mechanism 63 which traverses the platten by means of a rod 64 having a screwed thread which is rotated by means of cogged wheel 65 which is also fitted to the platten 62. The screwed thread engages a block 67 which includes a cutting wheel 68 fastened via a fastener 69. Also mounted to the block 67 is a counter actuator which includes a prong 71. The prong 71 acts to rotate the dial mechanism 44 of Fig. 6 upon the return traversal of the cutting wheel. As shown previously in Fig. 6, the dial mechanism 44 includes a cogged surface which interacts with pawl lever 73, thereby maintaining a count of the number of photographs taken on the surface of dial mechanism 44. The cutting mechanism 63 is inserted into the platten base 62 by means of a snap fit via receptacle eg. 74.

The platten 62 includes an internal recapping mechanism 80 for recapping the print head when not in use. The recapping mechanism 80 includes a sponge portion 81 and is operated via a solenoid coil so as to provide for recapping of the print head. In the preferred embodiment, there is provided an inexpensive form of printhead re-capping mechanism provided for incorporation into a handheld camera system so as to provide for printhead re-capping of an inkjet printhead.

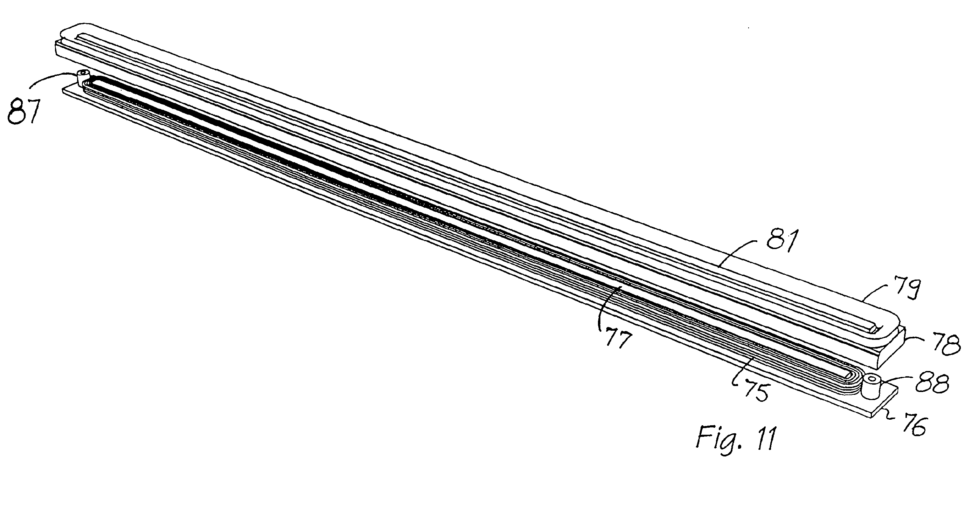

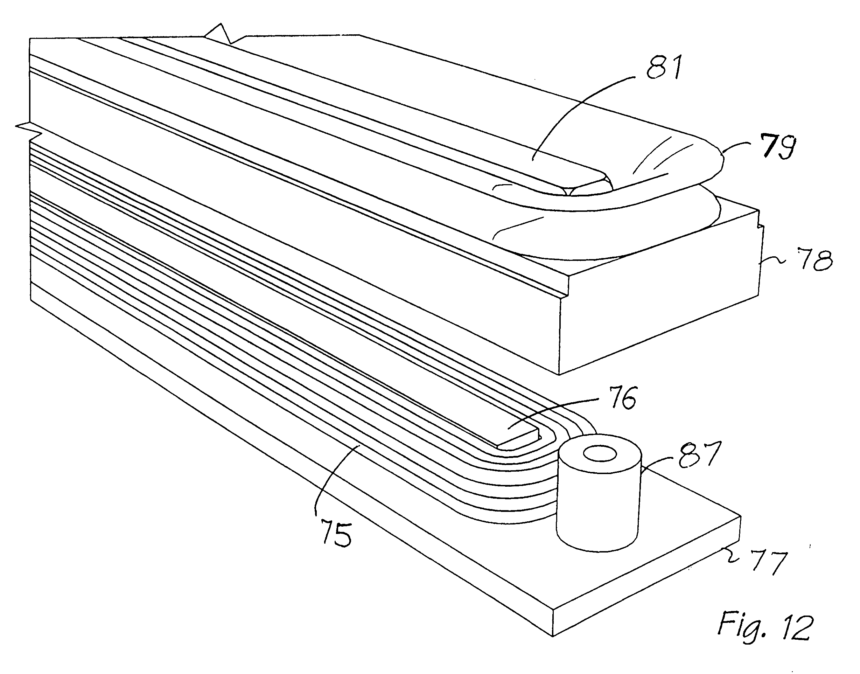

Fig. 11 illustrates an exploded view of the recapping mechanism whilst Fig. 12 illustrates a close up of the end portion thereof. The re-capping mechanism 90 is structured around a solenoid including a 16 turn coil 75 which can comprise insulated wire. The coil 75 is turned around a first stationery solenoid arm 76 which is mounted on a bottom surface of the pattern 62(Fig. 8) and includes a post portion 77 to magnify effectiveness of operation. The arm 76 can comprise a ferrous material.

A second moveable arm of the solenoid actuator is also provided 78. The arm 78 being moveable and also made of ferrous material. Mounted on the arm is a sponge portion surrounded by an elastomer strip 79. The elastomer strip 79 is of a generally arcuate cross-section and act as a leaf springs against the surface of the printhead ink supply cartridge 42 (Fig. 5) so as to provide for a seal against the surface of the printhead ink supply cartridge 42. In the quiescent position a elastomer spring units 87, 88 act to resiliently deform the elastomer seal 79 against the surface of the ink supply unit 42.

When it is desired to operate the printhead unit, upon the insertion of paper, the solenoid coil 75 is activated so as to cause the arm 78 to move down to be adjacent to the end plate 76. The arm 78 is held against end plate 76 while the printhead is printing by means of a small "keeper current" in coil 77. Simulation results indicate that the keeper current can be significantly less than the actuation current. Subsequently, after photo printing, the paper is guillotined by the cutting mechanism 63 of Fig. 8 acting against Aluminium Strip 43 of Fig. 5, and rewound so as to clear the area of the re-capping mechanism 88. Subsequently, the current is turned off and springs 87, 88 return the arm 78 so that the elastomer seal is again resting against the printhead ink supply cartridge.

It can be seen that the preferred embodiment provides for a simple and inexpensive means of re-capping a printhead through the utilisation of a solenoid type device having a long rectangular form. Further, the preferred embodiment utilises minimal power in that currents are only required whilst the device is operational and additionally, only a low keeper current is required whilst the printhead is printing.

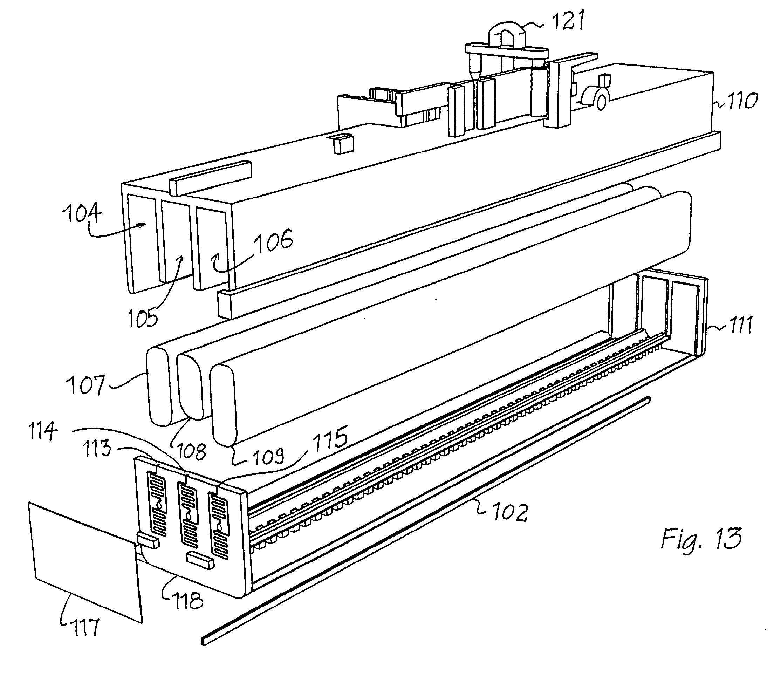

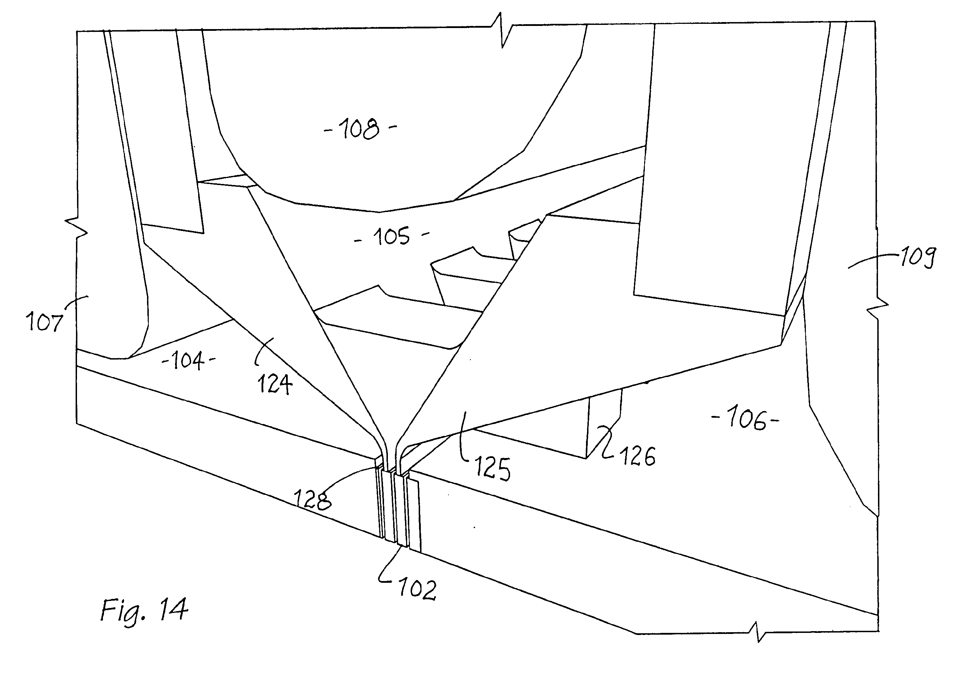

Turning next to Fig. 13 and 14, Fig. 13 illustrates an exploded perspective of the ink supply cartridge 42 whilst Fig. 14 illustrates a close up sectional view of a bottom of the ink supply cartridge with the printhead unit in place. The ink supply cartridge 42 is based around a pagewidth printhead 102 which comprises a long slither of silicon having a series of holes etched on the back surface for the supply of ink to a front surface of the silicon wafer for subsequent ejection via a micro electro mechanical system. The form of ejection can be many different forms such as those set out in the relevant provisional patent specifications of the attached appendix. In particular, the ink jet printing system set out in provisional patent specification entitled "An Image Creation Method and Apparatus (IJ38)" filed concurrently herewith is highly suitable. Of course, many other inkjet technologies, as referred to the attached appendix, can also be utilised when constructing a printhead unit 102. The fundamental requirement of the ink supply cartridge 42 being the supply of ink to a series of colour channels etched through the back surface of the printhead 102. In the description of the preferred embodiment, it is assumed that a three colour printing process is to be utilised so as to provide full colour picture output. Hence, the print supply unit 42 includes three ink supply reservoirs being a cyan reservoir 104, a magenta reservoir 105 and a yellow reservoir 106. Each of these reservoirs is required to store ink and includes a corresponding sponge type material 107 - 109 which assists in stabilising ink within the corresponding ink channel and therefore preventing the ink from sloshing back and forth when the printhead is utilised in a handheld camera system. The reservoirs 104, 105, 106 are formed through the mating of first exterior plastic piece 110 mating with a second base piece) 111.

At a first end of the base piece 11 includes a series of air inlet 113 - 115. The air inlet leads to a corresponding winding channel which is hydrophobically treated so as to act as an ink repellent and therefore repel any ink that may flow along the air inlet channel. The air inlet channel further takes a convoluted path further assisting in resisting any ink flow out of the chambers 104 - 106. An adhesive tape portion 117 is provided for sealing the channels within end portion 118.

At the top end, there is included a series of refill holes for refilling corresponding ink supply chambers 104, 105, 106. A plug 121 is provided for sealing the refill holes.

Turning now to Fig. 14, there is illustrated a close up perspective view, partly in section through the ink supply cartridge 42 of Fig. 13 when formed as a unit. The ink supply cartridge includes the three colour ink reservoirs 104, 105, 106 which supply ink to different portions of the back surface of printhead 102 which includes a series of apertures 128 defined therein for carriage of the ink to the front surface.

The ink supply unit includes two guide walls 124, 125 which separate the various ink chambers and are tapered into an end portion abutting the surface of the printhead 102. The guide walls are further mechanically supported and regular spaces by a block portions eg. 126 which are placed at regular intervals along the length of the printhead supply unit. The block portions 126 leaving space at portions close to the back of printhead 102 for the flow of ink around the back surface thereof.

The printhead supply unit is preferably formed from a multi-part plastic injection mould and the mould pieces eg. 10, 11 (Fig. 1) snap together around the sponge pieces 107, 109. Subsequently, a syringe type device can be inserted in the ink refill holes and the ink reservoirs filled with ink with the air flowing out of the air outlets 113 - 115. Subsequently, the adhesive tape portion 117 and plug 121 are attached and the printhead tested for operation capabilities. Subsequently, the ink supply cartridge 42 can be readily removed for refilling by means of removing the ink supply cartridge, performing a washing cycle, and then utilising the holes for the insertion of a refill syringe filled with ink for refilling the ink chamber before returning the ink supply cartridge 42 to a camera.

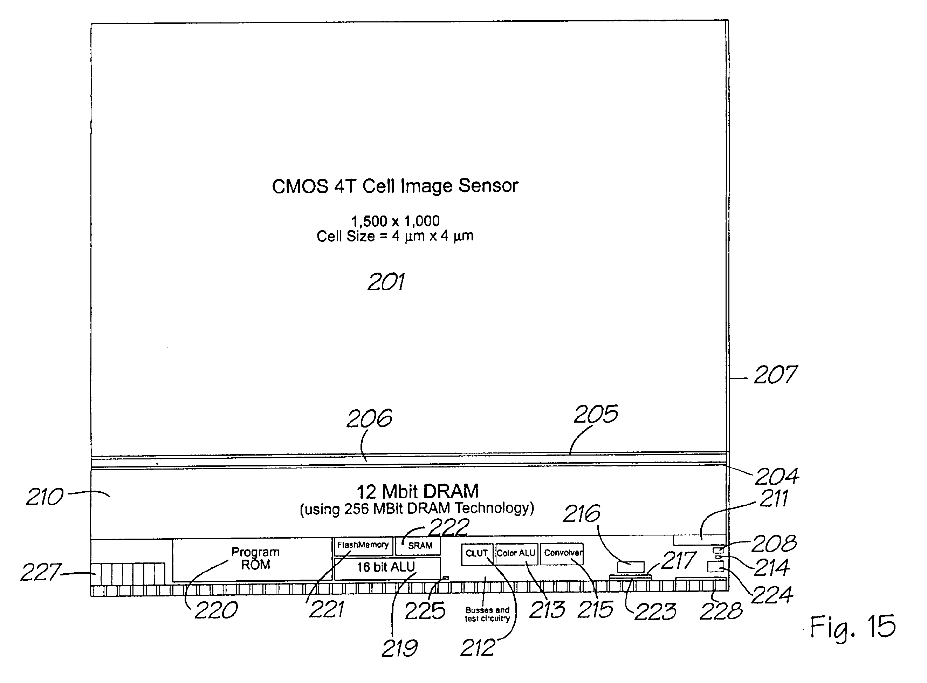

Turning now to Fig. 15, there is shown an example layout of the Image Capture and Processing Chip (ICP) 48.
The Image Capture and Processing Chip 48 provides most of the electronic functionality of the camera with the exception of the print head chip. The chip 48 is a highly integrated system. It combines CMOS image sensing, analog to digital conversion, digital image processing, DRAM storage, ROM, and miscellaneous control functions in a single chip.

The chip is estimated to be around 32 mm² using a leading edge 0.18 micron CMOS/DRAM/APS process. The chip size and cost can scale somewhat with Moore's law, but is dominated by a CMOS active pixel sensor array 201, so scaling is limited as the sensor pixels approach the diffraction limit.

The ICP 48 includes CMOS logic, a CMOS image sensor, DRAM, and analog circuitry. A very small amount of flash memory or other non-volatile memory is also preferably included for protection against reverse engineering.

Alternatively, the ICP can readily be divided into two chips: one for the CMOS imaging array, and the other for the remaining circuitry. The cost of this two chip solution should not be significantly different than the single chip ICP, as the extra cost of packaging and bond-pad area is somewhat cancelled by the reduced total wafer area requiring the color filter fabrication steps.
The ICP preferably contains the following functions:

| Function |
|---|
| 1.5 megapixel image sensor |
| Analog Signal Processors |
| Image sensor column decoders |
| Image sensor row decoders |
| Analogue to Digital Conversion (ADC) |
| Column ADC's |
| Auto exposure |
| 12 Mbits of DRAM |
| DRAM Address Generator |
| Color interpolator |
| Convolver |
| Color ALU |
| Halftone matrix ROM |
| Digital halftoning |
| Print head interface |
| 8 bit CPU core |
| Program ROM |
| Flash memory |
| Scratchpad SRAM |
| Parallel interface (8 bit) |
| Motor drive transistors (5) |
| Clock PLL |
| JTAG test interface |
| Test circuits |
| Busses |
| Bond pads |

The CPU, DRAM, Image sensor, ROM, Flash memory, Parallel interface, JTAG interface and ADC can be vendor supplied cores. The ICP is intended to run on 1.5V to minimize power consumption and allow convenient operation from two AA type battery cells.

Fig. 15 illustrates a layout of the ICP 48. The ICP 48 is dominated by the imaging array 201, which consumes around 80% of the chip area. The imaging array is a CMOS 4 transistor active pixel design with a resolution of 1,500 x 1,000. The array can be divided into the conventional configuration, with two green pixels, one red pixel, and one blue pixel in each pixel group. There are 750 x 500 pixel groups in the imaging array.

The latest advances in the field of image sensing and CMOS image sensing in particular can be found in the October, 1997 issue of IEEE Transactions on Electron Devices and, in particular, pages 1689 to 1968. Further, a specific implementation similar to that disclosed in the present application is disclosed in Wong et. al, "CMOS Active Pixel Image Sensors Fabricated Using a 1.8V, 0.25 µm CMOS Technology", IEDM 1996, page 915

The imaging array uses a 4 transistor active pixel design of a standard configuration. To minimize chip area and therefore cost, the image sensor pixels should be as small as feasible with the technology available. With a four transistor cell, the typical pixel size scales as 20 times the lithographic feature size. This allows a minimum pixel area of around 3.6 µm x 3.6 µm. However, the photosite must be substantially above the diffraction limit of the lens. It is also advantageous to have a square photosite, to maximize the margin over the diffraction limit in both horizontal and vertical directions. In this case, the photosite can be specified as 2.5 µm x 2.5 µm. The photosite can be a photogate, pinned photodiode, charge modulation device, or other sensor.

The four transistors are packed as an 'L' shape, rather than a rectangular region, to allow both the pixel and the photosite to be square. This reduces the transistor packing density slightly, increasing pixel size. However, the advantage in avoiding the diffraction limit is greater than the small decrease in packing density.

The transistors also have a gate length which is longer than the minimum for the process technology. These have been increased from a drawn length of 0.18 micron to a drawn length of 0.36 micron. This is to improve the transistor matching by making the variations in gate length represent a smaller proportion of the total gate length.

The extra gate length, and the 'L' shaped packing, mean that the transistors use more area than the minimum for the technology. Normally, around 8 µm² would be required for rectangular packing. Preferably, 9.75 µm² has been allowed for the transistors.

The total area for each pixel is 16 µm², resulting from a pixel size of 4 µm x 4 µm. With a resolution of 1,500 x 1,000, the area of the imaging array 101 is 6,000 µm x 4,000 µm, or 24 mm².

The presence of a color image sensor on the chip affects the process required in two major ways:
- The CMOS fabrication process should be optimized to minimize dark current
- Color filters are required. These can be fabricated using dyed photosensitive polyimides, resulting in an added process complexity of three spin coatings, three photolithographic steps, three development steps, and three hardbakes.

There are 15,000 analog signal processors (ASPs) 205, one for each of the columns of the sensor. The ASPs amplify the signal, provide a dark current reference, sample and hold the signal, and suppress the fixed pattern noise (FPN).

There are 375 analog to digital converters 206, one for each four columns of the sensor array. These may be delta-sigma or successive approximation type ADC's. A row of low column ADC's are used to reduce the conversion speed required, and the amount of analog signal degradation incurred before the signal is converted to digital. This also eliminates the hot spot (affecting local dark current) and the substrate coupled noise that would occur if a single high speed ADC was used. Each ADC also has two four bit DAC's which trim the offset and scale of the ADC to further reduce FPN variations between columns. These DAC's are controlled by data stored in flash memory during chip testing.

The column select logic 204 is a 1:1500 decoder which enables the appropriate digital output of the ADCs onto the output bus. As each ADC is shared by four columns, the least significant two bits of the row select control 4 input analog multiplexors.

A row decoder 207 is a 1:1000 decoder which enables the appropriate row of the active pixel sensor array. This selects which of the 1000 rows of the imaging array is connected to analog signal processors. As the rows are always accessed in sequence, the row select logic can be implemented as a shift register.

An auto exposure system 208 adjusts the reference voltage of the ADC 205 in response to the maximum intensity sensed during the previous frame period. Data from the green pixels is passed through a digital peak detector. The peak value of the image frame period before capture (the reference frame) is provided to a digital to analogue converter(DAC), which generates the global reference voltage for the column ADCs. The peak detector is reset at the beginning of the reference frame. The minimum and maximum values of the three RGB color components are also collected for color correction.

The second largest section of the chip is consumed by a DRAM 210 used to hold the image. To store the 1,500 x 1,000 image from the sensor without compression, 1.5 Mbytes of DRAM 210 are required. This equals 12 Mbits, or slightly less than 5% of a 256 Mbit DRAM. The DRAM technology assumed is of the 256 Mbit generation implemented using 0.18µm CMOS.

Using a standard 8F cell, the area taken by the memory array is 3.11 mm². When row decoders, column sensors, redundancy, and other factors are taken into account, the DRAM requires around 4 mm².

This DRAM 210 can be mostly eliminated if analog storage of the image signal can be accurately maintained in the CMOS imaging array for the two seconds required to print the photo. However, digital storage of the image is preferable as it is maintained without degradation, is insensitive to noise, and allows copies of the photo to be printed considerably later.

A DRAM address generator 211 provides the write and read addresses to the DRAM 210. Under normal operation, the write address is determined by the order of the data read from the CMOS image sensor 201. This will typically be a simple raster format. However, the data can be read from the sensor 201 in any order, if matching write addresses to the DRAM are generated. The read order from the DRAM 210 will normally simply match the requirements of a color interpolator and the print head. As the cyan, magenta, and yellow rows of the print head are necessarily offset by a few pixels to allow space for nozzle actuators, the colors are not read from the DRAM simultaneously. However, there is plenty of time to read all of the data from the DRAM many times during the printing process. This capability is used to eliminate the need for FIFOs in the print head interface, thereby saving chip area. All three RGB image components can be read from the DRAM each time color data is required. This allows a color space converter to provide a more sophisticated conversion than a simple linear RGB to CMY conversion.

Also, to allow two dimensional filtering of the image data without requiring line buffers, data is re-read from the DRAM array.

The address generator may also implement image effects in certain models of camera. For example, passport photos are generated by a manipulation of the read addresses to the DRAM. Also, image framing effects (where the central image is reduced), image warps, and kaleidoscopic effects can all be generated by manipulating the read addresses of the DRAM.

While the address generator 211 may be implemented with substantial complexity if effects are built into the standard chip, the chip area required for the address generator is small, as it consists only of address counters and a moderate amount of random logic.

A color interpolator 214 converts the interleaved pattern of red, 2 x green, and blue pixels into RGB pixels. It consists of three 8 bit adders and associated registers. The divisions are by either 2 (for green) or 4 (for red and blue) so they can be implemented as fixed shifts in the output connections of the adders.

A convolver 215 is provided as a sharpening filter which applies a small convolution kernel (5 x 5) to the red, green, and blue planes of the image. The convolution kernel for the green plane is different from that of the red and blue planes, as green has twice as many samples. The sharpening filter has five functions:
- To improve the color interpolation from the linear interpolation provided by the color interpolator, to a close approximation of a sinc interpolation.
- To compensate for the image 'softening' which occurs during digitization.
- To adjust the image sharpness to match average consumer preferences, which are typically for the image to be slightly sharper than reality. As the single use camera is intended as a consumer product, and not a professional photographic products, the processing can match the most popular settings, rather than the most accurate.
- To suppress the sharpening of high frequency (individual pixel) noise. The function is similar to the 'unsharp mask' process.
- To antialias Image Warping.

These functions are all combined into a single convolution matrix. As the pixel rate is low (less than I Mpixel per second) the total number of multiplies required for the three color channels is 56 million multiplies per second. This can be provided by a single multiplier. Fifty bytes of coefficient ROM are also required.

A color ALU 113 combines the functions of color compensation and color space conversion into the one matrix multiplication, which is applied to every pixel of the frame. As with sharpening, the color correction should match the most popular settings, rather than the most accurate.

A color compensation circuit of the color ALU provides compensation for the lighting of the photo. The vast majority of photographs are substantially improved by a simple color compensation, which independently normalizes the contrast and brightness of the three color components.

A color look-up table (CLUT) 212 is provided for each color component. These are three separate 256 x 8 SRAMs, requiring a total of 6,144 bits. The CLUTs are used as part of the color correction process. They are also used for color special effects, such as stochastically selected "wild color" effects.

A color space conversion system of the color ALU converts from the RGB color space of the image sensor to the CMY color space of the printer. The simplest conversion is a I's complement of the RGB data. However, this simple conversion assumes perfect linearity of both color spaces, and perfect dye spectra for both the color filters of the image sensor, and the ink dyes. At the other extreme is a tri-linear interpolation of a sampled three dimensional arbitrary transform table. This can effectively match any non-linearity or differences in either color space. Such a system is usually necessary to obtain good color space conversion when the print engine is a color electrophotographic

However, since the non-linearity of a halftoned ink jet output is very small, a simpler system can be used. A simple matrix multiply can provide excellent results. This requires nine multiplies and six additions per contone pixel. However, since the contone pixel rate is low (less than 1 Mpixel/sec) these operations can share a single multiplier and adder. The multiplier and adder are used in a color ALU which is shared with the color compensation function.

Digital halftoning can performed as a dispersed dot ordered dither using a stochastic optimized dither cell. A halftone matrix ROM 116 is provided for storing dither cell coefficients. A dither cell size of 32 x 32 is adequate to ensure that the cell repeat cycle is not visible. The three colors - cyan, magenta, and yellow - are all dithered using the same cell, to ensure maximum co-positioning of the ink dots. This minimizes 'muddying' of the mid-tones which results from bleed of dyes from one dot to adjacent dots while still wet. The total ROM size required is I KByte, as the one ROM is shared by the halftoning units for each of the three colors.

The digital halftoning used is dispersed dot ordered dither with stochastic optimized dither matrix. While dithering does not produce an image quite as 'sharp' as error diffusion, it does produce a more accurate image with fewer artifacts. The image sharpening produced by error diffusion is artificial, and less controllable and accurate than 'unsharp mask' filtering performed in the contone domain. The high print resolution (1,600 dpi x 1,600 dpi) results in excellent quality when using a well formed stochastic dither matrix.

Digital halftoning is performed by a digital halftoning unit 217 using a simple comparison between the contone information from the DRAM 210 and the contents of the dither matrix 216. During the halftone process, the resolution of the image is changed from the 250 dpi of the captured contone image to the 1,600 dpi of the printed image. Each contone pixel is converted to an average of 40.96 halftone dots.

The ICP incorporates an 16 bit microcontroller CPU core 219 to run the miscellaneous camera functions, such as reading the buttons, controlling the motor and solenoids, setting up the hardware, and authenticating the refill station. The processing power required by the CPU is very modest, and a wide variety of processor cores can be used. As the entire CPU program is run from a small ROM 220. Program compatibility between camera versions is not important, as no external programs are run. A 2 Mbit (256 Kbyte) program and data ROM 220 is included on chip. Most of this ROM space is allocated to data for outline graphics and fonts for specialty cameras. The program requirements are minor. The single most complex task is the encrypted authentication of the refill station. The ROM requires a single transistor per bit.

A Flash memory 221 may be used to store a 128 bit authentication code. This provides higher security than storage of the authentication code in ROM, as reverse engineering can be made essentially impossible. The Flash memory is completely covered by third level metal, making the data impossible to extract using scanning probe microscopes or electron beams. The authentication code is stored in the chip when manufactured. At least two other Flash bits are required for the authentication process: a bit which locks out reprogramming of the authentication code, and a bit which indicates that the camera has been refilled by an authenticated refill station. The flash memory can also be used to store FPN correction data for the imaging array. Additionally, a phase locked loop rescaling parameter is stored is provided for scaling the clocking cycle to an appropriate correct time. The clock frequency does not require crystal accuracy since no date functions are provided. To eliminate the cost of a crystal, an on chip oscillator with a phase locked loop 124 is used. As the frequency of an on-chip oscillator is highly variable from chip to chip, the frequency ratio of the oscillator to the PLL is digitally trimmed during initial testing. The value is stored in Flash memory 121. This allows the clock PLL to control the ink-jet heater pulse width with sufficient accuracy.

A scratchpad SRAM is a small static RAM 222 with a 6T cell. The scratchpad provided temporary memory for the 16 bit CPU. 1024 bytes is adequate.

A print head interface 223 formats the data correctly for the print head. The print head interface also provides all of the timing signals required by the print head. These timing signals may vary depending upon temperature, the number of dots printed simultaneously, the print medium in the print roll, and the dye density of the ink in the print roll.

The following is a table of external connections to the print head interface:

| Connection | Function | Pins |
|---|---|---|
| DataBits[0-7] | Independent serial data to the eight segments of the print head | 8 |
| BitClock | Main data clock for the print head | 1 |
| ColorEnable[0-2] | Independent enable signals for the CMY actuators, allowing different pulse times for each color. | 3 |
| BankEnable[0-1] | Allows either simultaneous or interleaved actuation of two banks of nozzles. This allows two different print speed/power consumption tradeoffs | 2 |
| NozzleSelect[0-4] | Selects one of 32 banks of nozzles for simultaneous actuation | 5 |
| ParallelXferClock | Loads the parallel transfer register with the data from the shift registers | 1 |
| Total | | 20 |

requires a single transistor per bit.

A Flash memory 221 may be used to store a 128 bit authentication code. This provides higher security than storage of the authentication code in ROM, as reverse engineering can be made essentially impossible. The Flash memory is completely covered by third level metal, making the data impossible to extract using scanning probe microscopes or electron beams. The authentication code is stored in the chip when manufactured. At least two other Flash bits are required for the authentication process: a bit which locks out reprogramming of the authentication code, and a bit which indicates that the camera has been refilled by an authenticated refill station. The flash memory can also be used to store FPN correction data for the imaging array. Additionally, a phase locked loop rescaling parameter is stored is provided for scaling the clocking cycle to an appropriate correct time. The clock frequency does not require crystal accuracy since no date functions are provided. To eliminate the cost of a crystal, an on chip oscillator with a phase locked loop 124 is used. As the frequency of an on-chip oscillator is highly variable from chip to chip, the frequency ratio of the oscillator to the PLL is digitally trimmed during initial testing. The value is stored in Flash memory 121. This allows the clock PLL to control the ink-jet heater pulse width with sufficient accuracy.

A scratchpad SRAM is a small static RAM 222 with a 6T cell. The scratchpad provided temporary memory for the 16 bit CPU. 1024 bytes is adequate.

A print head interface 223 formats the data correctly for the print head. The print head interface also provides all of the timing signals required by the print head. These timing signals may vary depending upon temperature, the number of dots printed simultaneously, the print medium in the print roll, and the dye density of the ink in the print roll.

The following is a table of external connections to the print head interface:

| Connection | Function | Pins |
|---|---|---|
| DataBits[0-7] | Independent serial data to the eight segments of the print head | 8 |
| BitClock | Main data clock for the print head | 1 |
| ColorEnable[0-2] | Independent enable signals for the CMY actuators, allowing different pulse times for each color. | 3 |
| BankEnable[0-1] | Allows either simultaneous or interleaved actuation of two banks of nozzles. This allows two different print speed/power consumption tradeoffs | 2 |
| NozzleSelect[0-4] | Selects one of 32 banks of nozzles for simultaneous actuation | 5 |
| ParallelXferClock | Loads the parallel transfer register with the data from the shift registers | 1 |
| Total | | 20 |

The print head utilized is composed of eight identical segments, each 1.25 cm long. There is no connection between the segments on the print head chip. Any connections required are made in the external TAB bonding film, which is double sided. The division into eight identical segments is to simplify lithography using wafer steppers. The segment width of 1.25 cm fits easily into a stepper field. As the print head chip is long and narrow (10 cm x 0.3 mm), the stepper field contains a single segment of 32 print head chips. The stepper field is therefore 1.25 cm x 1.6 cm. An average of four complete print heads are patterned in each wafer step. never driven at the same time as the image sensor is used. This is to avoid voltage fluctuations and hot spots affecting the image quality. Further, the transistors are located as far away from the sensor as possible.

A standard JTAG (Joint Test Action Group) interface 228 is included in the ICP for testing purposes and for interrogation by the refill station. Due to the complexity of the chip, a variety of testing techniques are required, including BIST (Built In Self Test) and functional block isolation. An overhead of 10% in chip area is assumed for chip testing circuitry for the random logic portions. The overhead for the large arrays the image sensor and the DRAM) is smaller.

The JTAG interface is also used for authentication of the refill station. This is included to ensure that the cameras are only refilled with quality paper and ink at a properly constructed refill station, thus preventing inferior quality refills from occurring. The camera must authenticate the refill station, rather than vice versa. The secure protocol is communicated to the refill station during the automated test procedure. Contact is made to four gold plated spots on the ICP/print head TAB by the refill station as the new ink is injected into the print head.

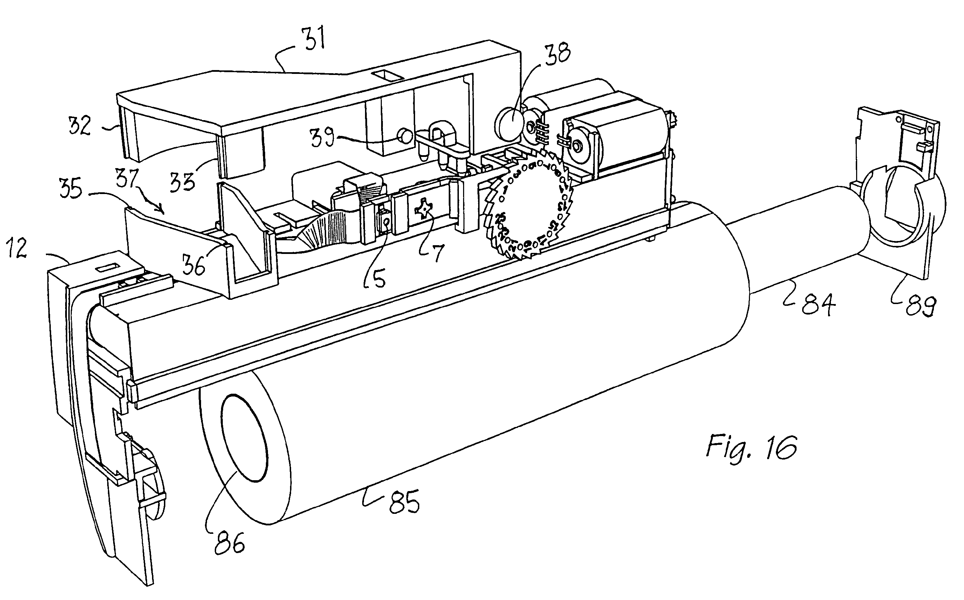

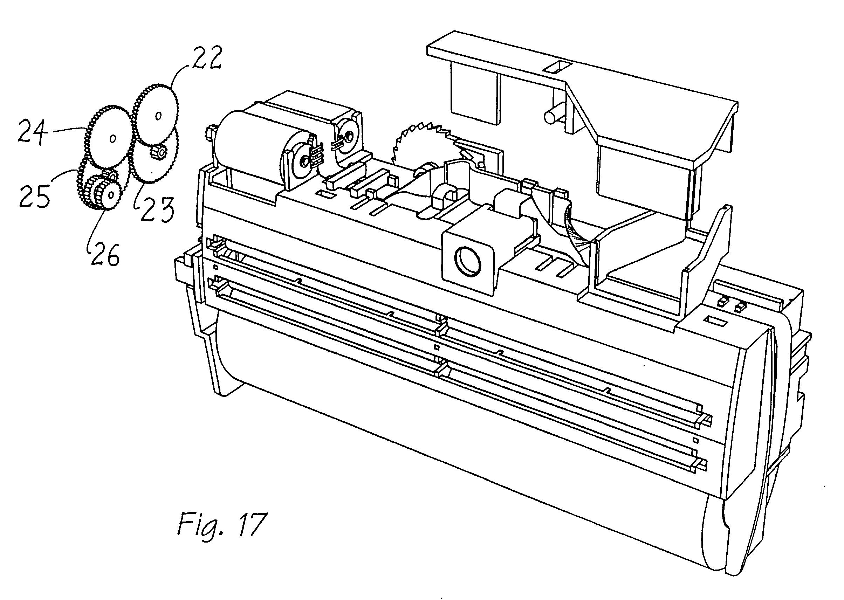

Fig. 16 illustrates rear view of the next step in the construction process whilst Fig. 17 illustrates a front camera view.

Turning now to Fig. 16, the assembly of the camera system proceeds via first assembling the ink supply mechanism 40. The flex PCB is interconnected with batteries only one 84 of which is shown, which are inserted in the middle portion of a print roll 85 which is wrapped around a plastic former 86. An end cap 89 is provided at the other end of the print roll 85 so as to fasten the print roll and batteries firmly to the ink supply mechanism.

The solenoid coil is interconnected (not shown) to interconnects 97, 98 (Fig. 8) which include leaf spring ends for interconnection with electrical contacts on the Flex PCB so as to provide for electrical control of the solenoid.

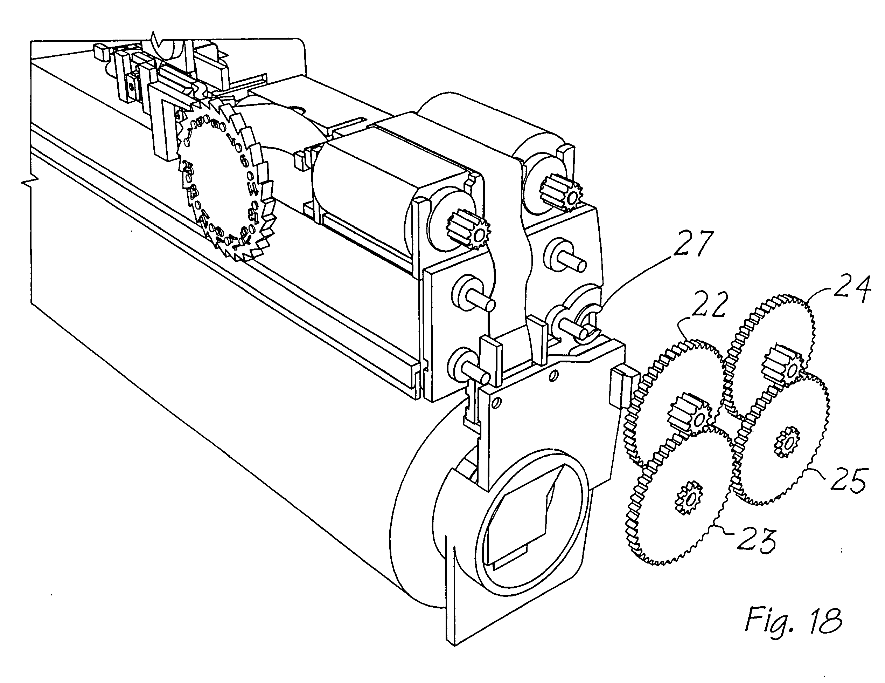

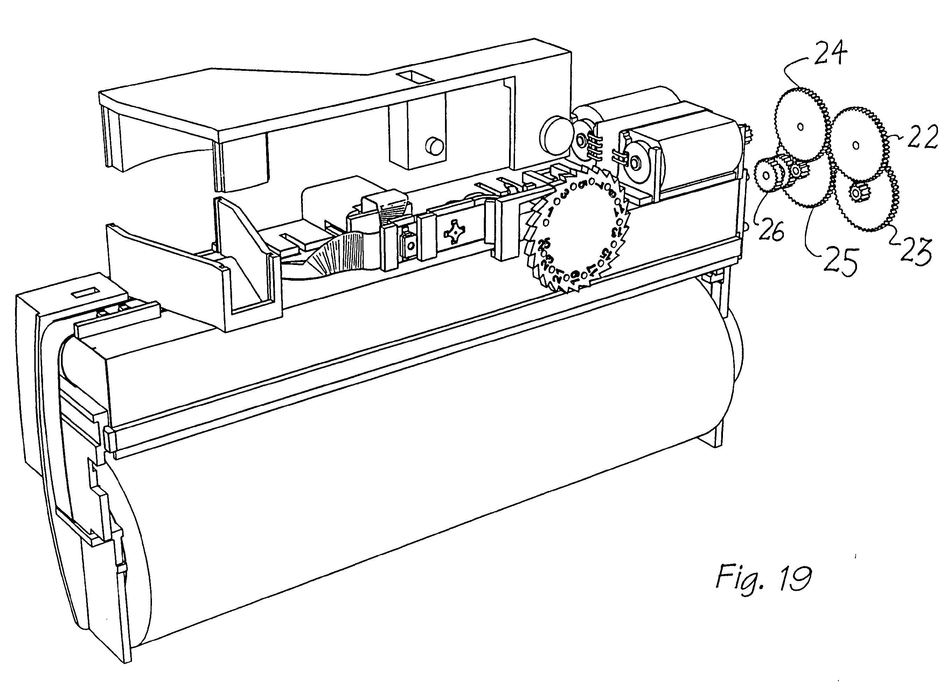

Turning now to Figs. 17 - 19 the next step in the construction process is the insertion of the relevant gear chains into the side of the camera chassis. Fig. 17 illustrates a front camera view, Fig. 18 illustrates a back side view and Fig. 19 also illustrates a back side view. The first gear chain comprising gear wheels 22, 23 are utilised for driving the guillotine blade with the gear wheel 23 engaging the gear wheel 65 of Fig. 8. The second gear chain comprising gear wheels 24, 25 and 26 engage one end of the print roller 61 of Fig. 8. As best indicated in Fig. 18, the gear wheels mate with corresponding buttons on the surface of the chassis with the gear wheel 26 being snap fitted into corresponding mating hole 27.

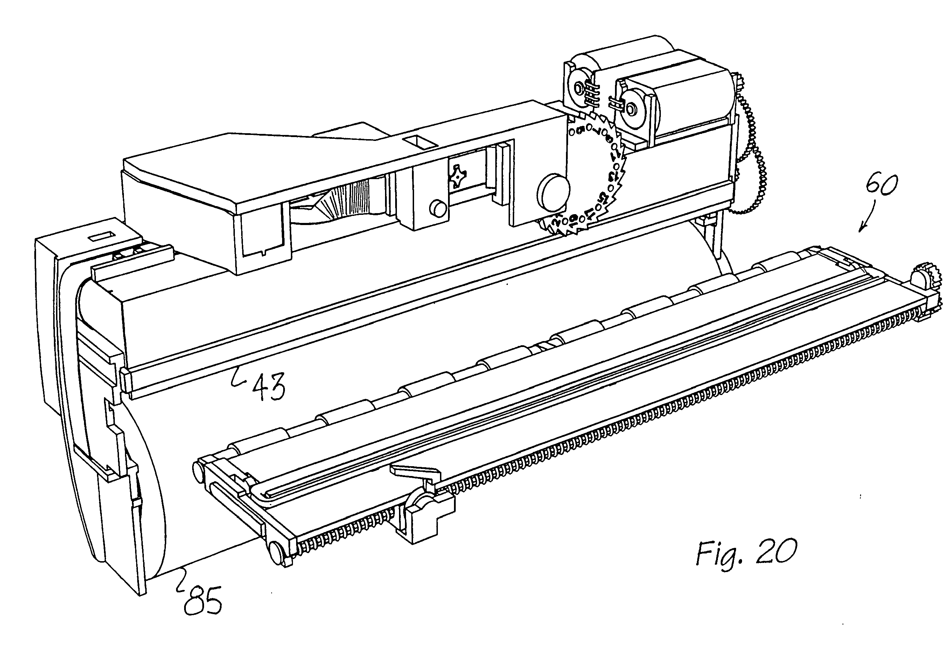

Next, as illustrated in Fig. 20, the assembled platten unit is then inserted between the print roll 85 and aluminium cutting blade 43.

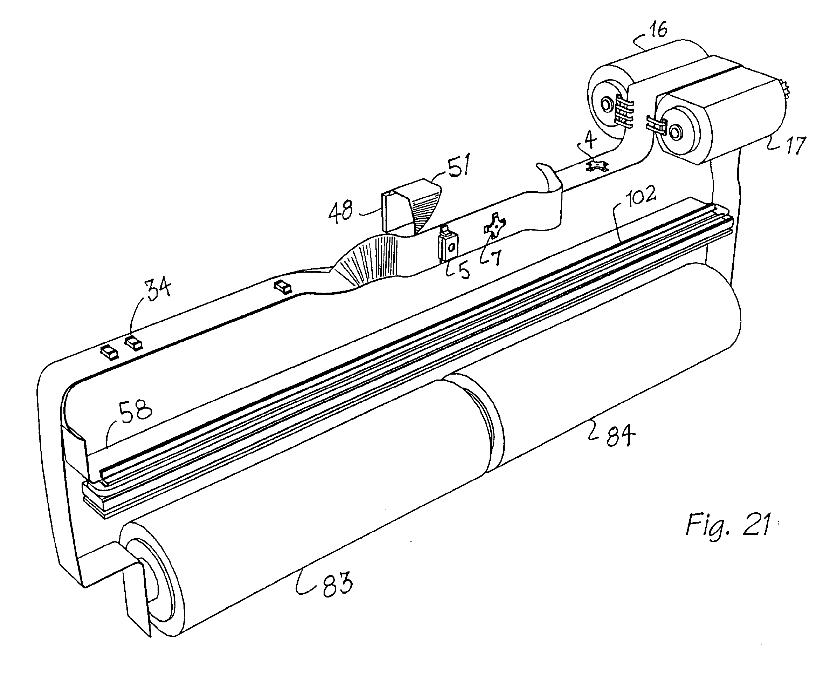

Turning now to Fig. 21, by way of illumination, there is illustrated the electrically interactive components of the camera system. As noted previously, the components are based around a Flex PCB board and include a TAB film 58 which interconnects the printhead 102 with the image sensor and processing chip 51. Power is supplied by two AA type batteries 83, 84 and a paper drive stepper motor 16 is provided in addition to a rotary guillotine motor 20.

An optical element 31 is provided for snapping into a top portion of the chassis 12. The optical element 31 includes portions defining an optical view finder 32, 33 which are slotted into mating portions 35, 36 in view finder channel 37. Also provided in the optical element 31 is a lensing system 38 for magnification of the prints left number in addition to an optical pipe element 39 for piping light from the LED 5 for external display.

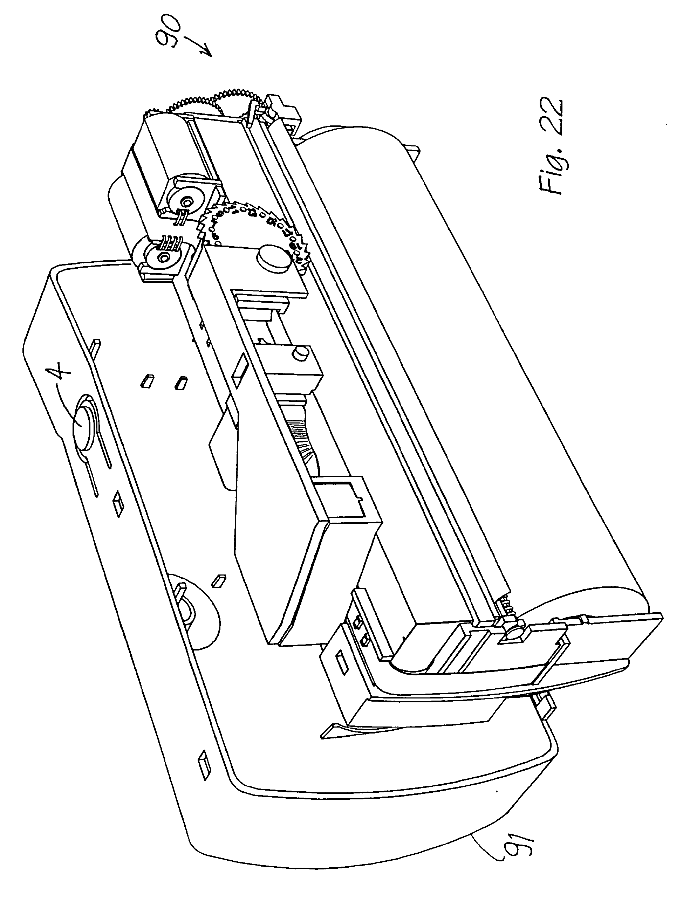

Turning next to Fig. 22, the assembled unit 90 is then inserted into a front outer case 91 which includes button 4 for activation of printouts.

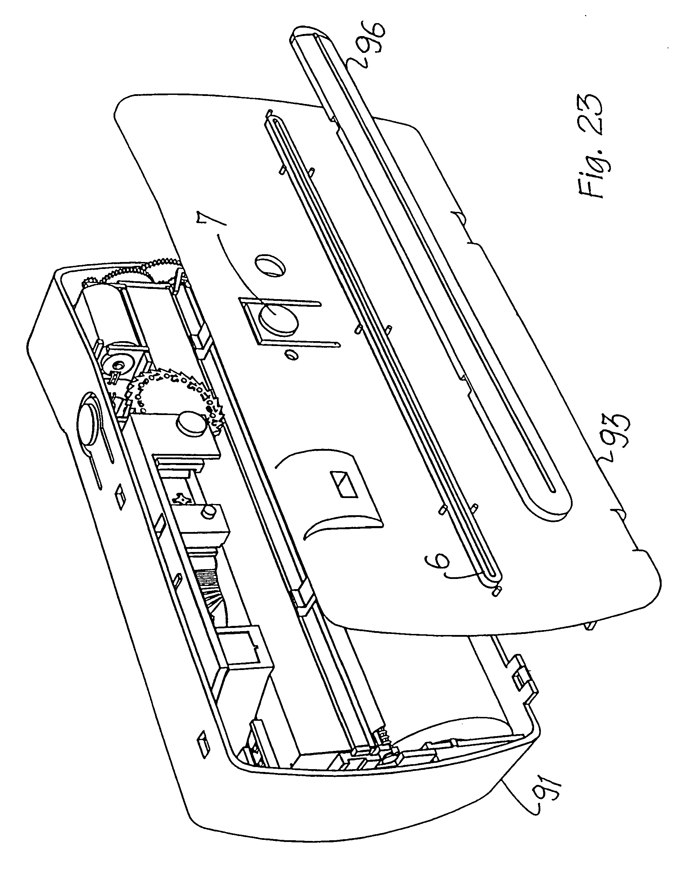

Turning now to Fig. 23, next, the unit 92 is provided with a snap-on back cover 93 which includes a slot 6 and copy print button 7. A wrapper label containing instructions and advertising (not shown) is then wrapped around the outer surface of the camera system and pinch clamped to the cover by means of clamp strip 96 which can comprise a flexible plastic or rubber strip.

Subsequently, the preferred embodiment is ready for use as a one time use camera system that provides for instant output images on demand. It will be evident that the preferred embodiment further provides for a refillable camera system. A used camera can be collected and its outer plastic cases removed and recycled. A new paper roll and batteries can be added and the ink cartridge refilled. A series of automatic test routines can then be carried out to ensure that the printer is properly operational. Further, in order to ensure only authorised refills are conducted so as to enhance quality, routines in the on-chip program ROM can be executed such that the camera authenticates the refilling station using a secure protocol Upon authentication, the camera can reset an internal paper count and an external case can be fitted on the camera system with a new outer label. Subsequent packing and shipping can then take place.

It will be further readily evident to those skilled in the art that the program ROM can be modified so as to allow for a variety of digital processing routines. In addition to the digitally enhanced photographs optimised for mainstream consumer preferences, various other models can readily be provided through mere re-programming of the program ROM. For example, a sepia classic old fashion style output can be provided through a remapping of the colour mapping function. A further alternative is to provide for black and white outputs again through a suitable colour remapping algorithm. Minimumless colour can also be provided to add a touch of colour to black and white prints to produce the effect that was traditionally used to colourize black and white photos. Further, passport photo output can be provided through suitable address remappings within the address generators. Further, edge filters can be utilised as is known in the field of image processing to produce sketched art styles. Further, classic wedding borders and designs can be placed around an output image in addition to the provision of relevant clip arts. For example, a wedding style camera might be provided. Further, a panoramic mode can be provided so as to output the well known panoramic format of images. Further, a postcard style output can be provided through the printing of postcards including postage on the back of a print roll surface. Further, cliparts can be provided for special events such as Halloween, Christmas etc. Further, kleidoscopic effects can be provided through address remappings and wild colour effects can be provided through remapping of the colour lookup table. Many other forms of special event cameras can be provided for example, cameras dedicated to the Olympics, movie tie-ins, advertising and other special events.

The operational mode of the camera can be programmed so that upon the depressing of the take photo a first image is sampled by the sensor array to determine irrelevant parameters. Next a second image is again captured which is utilised for the output. The captured image is then manipulated in accordance with any special requirements before being initially output on the paper roll. The LED light is then activated for a predetermined time during which the DRAM is refreshed so as to retain the image. If the print copy button is depressed during this predetermined time interval, a further copy of the photo is output. After the predetermined time interval where no use of the camera has occurred, the onboard CPU shuts down all power to the camera system until such time as the take button is again activated. In this way, substantial power savings can be realized.

### Ink Jet Technologies

The embodiments of the invention use an ink jet printer type device. Of course many different devices could be used. However presently popular ink jet printing technologies are unlikely to be suitable.

The most significant problem with thermal inkjet is power consumption. This is approximately 100 times that required for high speed, and stems from the energy-inefficient means of drop ejection. This involves the rapid boiling of water to produce a vapor bubble which expels the ink. Water has a very high heat capacity, and must be superheated in thermal inkjet applications. This leads to an efficiency of around 0.02%, from electricity input to drop momentum (and increased surface area) out.

The most significant problem with piezoelectric inkjet is size and cost Piezoelectric crystals have a very small deflection at reasonable drive voltages, and therefore require a large area for each nozzle. Also, each piezoelectric actuator must be connected to its drive circuit on a separate substrate. This is not a significant problem at the current limit of around 300 nozzles per print head, but is a major impediment to the fabrication of pagewide print heads with 19,200 nozzles.

Ideally, the inkjet technologies used meet the stringent requirements of in-camera digital color printing and other high quality, high speed, low cost printing applications. To meet the requirements of digital photography, new inkjet technologies have been created. The target features include:
low power (less than 10 Watts)
high resolution capability (1,600 dpi or more)
photographic quality output
low manufacturing cost
small size (pagewidth times minimum cross section)
high speed (< 2 seconds per page).

All of these features can be met or exceeded by the inkjet systems described previously by the present applicant.

## Claims

1. A handheld camera system (1) comprising:
a core chassis (12);
an ink cartridge unit (42) including an ink supply (104,105,106) and print head unit (102), said ink cartridge (42) unit being mounted on said chassis (12);
a roll of print media (85) rotatably mounted between end portions of said chassis (12), said print head unit (102) being adapted to print on said print media;
a platen unit (60) mounted below said print head unit (102);
image sensor and control circuitry (48) interconnected to said print head unit (102) and adapted to sense an image for printing by said print head unit;
an outer casing (2) for enclosing said chassis (12), said ink cartridge unit (42), said print media (85), said platen unit (60) and said circuitry (48), and
**characterized by**:
a cutting unit (63) for cutting printed sensed images, said cutting unit being mounted on said platen unit (60) and comprising:
a worm screw (64) extending the length of said printed sensed images; and
a worm gear (67) attached to said worm screw (64) and adapted to be driven the length of said printed sensed image, said worm gear including a cutting blade (68) for cutting said print media into separate sheets.

2. The camera system of claim 1, wherein said roll of print media (85) is wrapped around a former (86) and a power supply (83,84) is stored in a central cavity of said former.

## Patentansprüche

1. Ein tragbares Kamerasystem (1) umfassend:
ein Innenchassis (12);
eine Tintenpatroneneinheit (42), welche eine Tintenversorgung (104, 105, 106) und eine Druckkopfeinheit (102) beinhaltet, wobei die Tintenpatroneneinheit (42) auf dem Chassis (12) befestigt ist;
eine Printmedium(85)-Walze, welche zwischen Endstücken des Chassis (12) rotierbar befestigt ist, wobei die Druckkopfeinheit (102) so ausgebildet ist, dass sie auf das Printmedium druckt;
eine Drucktiegeleinheit (60), welche unterhalb der Druckkopfeinheit (102) befestigt ist;
ein Bildsensor- und Steuerungsschaltkreis (48), welcher mit der Druckkopfeinheit (102) verbunden und welcher so ausgebildet ist, dass ein Bild zum Drucken mittels der Druckkopfeinheit erkennbar ist;
ein äußeres Gehäuse (2) zum Umschließen des Chassis (12), der Tintenpatroneneinheit (42), des Printmediums (85), der Drucktiegeleinheit (60) und des Schaltkreises (48), und **gekennzeichnet durch**:
eine Schneideeinheit (63) zum Schneiden der erkannten gedruckten Bilder, wobei die Schneideeinheit auf der Drucktiegeleinheit (60) befestigt ist und umfasst:
eine Schneckenschraube (64), welche entlang der Länge der erkannten gedruckten Bilder verläuft; und
ein Schneckengetriebe (67), welches an der Schneckenschraube (64) angebracht und so ausgebildet ist, dass es entlang der Länge des erkannten gedruckten Bildes angetrieben wird, wobei das Schneckengetriebe eine Schneidklinge (68) zum Schneiden des Printmediums in einzelne Blätter beinhaltet.

2. Das Kamerasystem nach Anspruch 1, wobei die Printmedium(85)-Walze um eine Hülse (86) gewickelt ist und eine Stromversorgung (83, 84) in einem mittigen Hohlraum der Hülse gelagert ist.

## Revendications

1. Système formant appareil photographique portable (1), comprenant :
un châssis central (12);
une unité cartouche d'encre (42) comprenant une réserve d'encre (104, 105, 106) et une unité tête d'impression (102), ladite unité cartouche d'encre (42) étant installée sur ledit châssis (12);
un rouleau de supports d'impression (85) installé en rotation entre des parties d'extrémité dudit châssis (12), ladite unité tête d'impression (102) étant adaptée pour imprimer sur lesdits supports d'impression;
une unité rouleau d'impression (60) installée en dessous de ladite unité tête d'impression (102);
des circuits de capteur d'image et de commande (48) interconnectés à ladite unité tête d'impression (102) et adaptés pour détecter une image à imprimer par ladite unité tête d'impression;
un boîtier extérieur (2) pour entourer ledit châssis (12), ladite unité cartouche d'encre (42), lesdits supports d'impression (85), ladite unité rouleau d'impression (60) et lesdits circuits (48), et **caractérisé par**:
une unité de découpe (63) pour découper des images détectées imprimées, ladite unité de découpe étant installée sur ladite unité rouleau d'impression (60) et comprenant :
une vis sans fin (64) s'étendant sur la longueur desdites images détectées imprimées; et
un engrenage à vis sans fin (67) rattaché à ladite vis sans fin (64) et adapté pour être entraîné sur la longueur de ladite image détectée imprimée, ledit engrenage à vis sans fin comprenant une lame de découpe (68) pour découper lesdits supports d'impression en feuilles séparées.

2. Système formant appareil photographique selon la revendication 1, dans lequel ledit rouleau de supports d'impression (85) est enroulé autour d'un mandrin (86) et une alimentation électrique (83, 84) est logée dans une cavité centrale dudit mandrin.
